Europäisches Patentamt

European Patent Office

Office européen des brevets

(11) Numéro de publication: **0 242 898 B1**

# FASCICULE DE BREVET EUROPEEN

(45) Date de publication de fascicule du brevet: **28.07.93** (51) Int. Cl.5: **C30B 25/12**

(21) Numéro de dépôt: **87200478.3**

(22) Date de dépôt: **16.03.87**

(54) **Dispositif comprenant un suscepteur plan tournant parallèlement à un plan de référence autour d'un axe perpendiculaire à ce plan.**

(30) Priorité: **21.03.86 FR 8604078**

(43) Date de publication de la demande:
**28.10.87 Bulletin 87/44**

(45) Mention de la délivrance du brevet:
**28.07.93 Bulletin 93/30**

(84) Etats contractants désignés:
**DE FR GB IT**

(56) Documents cités:
**GB-A- 2 136 258**

**JOURNAL OF CRYSTAL GROWTH, vol. 69, nos 2/3, 11 novembre 1984, pages 641-643, Elsevier Science Publishers B.V., Amsterdam, NL; H.M. COX: "Vapor levitation epitaxy: A new concept in epitaxial crystal growth"**

(73) Titulaire: **LABORATOIRES D'ELECTRONIOUE PHILIPS**
**3, Avenue Descartes**
**F-94450 Limeil-Brévannes(FR)**
(84) Etats contractants désignés:
**FR**

(73) Titulaire: **N.V. Philips' Gloeilampenfabrieken**
**Groenewoudseweg 1**
**NL-5621 BA Eindhoven(NL)**
(84) Etats contractants désignés:
**DE GB IT**

(72) Inventeur: **Frijlink, Peter Michael Société Civile S.P.I.D.**
**209, rue de l'Université**
**F-75007 Paris(FR)**

(74) Mandataire: **Landousy, Christian**
**Société Civile S.P.I.D. 156, Boulevard Haussmann**
**F-75008 Paris (FR)**

Rank Xerox (UK) Business Services
(3. 10 / 3.6 / 3.3. 1)

## Description

L'invention concerne un dispositif comprenant un disque plan tournant parallèlement à un plan de référence et comprenant une structure de centrage de ce disque et des structures disposées dans le plan de référence pour mettre le disque en sustentation et en rotation par l'application d'un flux gazeux à la face arrière de ce disque.

L'invention concerne également une chambre de réacteur d'épitaxie en phase vapeur munie d'un tel dispositif.

L'invention trouve son application dans la réalisation de porte-échantillons plans tournants pour chambre d'épitaxie en phase vapeur, tout particulièrement pour la croissance épitaxiale en phase vapeur de couches de composés du groupe III-V pour former des dispositifs semiconducteurs.

L'utilisation de porte-échantillons rotatifs dans le domaine de la croissance épitaxiale en phase vapeur des composés du groupe III-V est connue de la publication intitulée "Multi-Wafer Growth of Extremely Uniform GaAs Layers by organometallic Vapor Phase Epitaxy" faite lors du : 1985, Electronic Materials Conference, University of Colorado, June 19/21, 1985" par S. Komeno, H.Tanaka, I.Itoh, et alii. Cette publication montre qu'il est d'importance, lors de la croissance de couches épitaxiales en phase vapeur, de faire tourner les échantillons afin d'obtenir des couches uniformes permettant de réaliser des composants de bonne qualité, tels que transistors à effet de champ, diodes, etc.

Mais les conditions dans lesquelles sont réalisées ces couches, conditions qui impliquent des hautes températures de l'ordre de 850°C, et une atmosphère contrôlée par exemple d'hydrogène, font que l'utilisation de méthodes classiques d'entraînement par moteur extérieur à la chambre est difficile à mettre en oeuvre.

En effet, dans cette application, le porte-échantillon doit se trouver en bon contact thermique avec un dispositif de chauffage afin de prévenir les variations de température dans l'échantillon, ces dernières entraînant des variations de l' homogénéité des couches épitaxiales réalisées en surface.

Il est connu du brevet GB N° 2 136 258, une méthode et un dispositif pour le traitement thermique de disques, et notamment de substrats semiconducteurs.

Selon ce document cité, dans une première mise en oeuvre le dispositif connu est destiné à la réalisation d'une couche de silice sur un substrat en silicium. A cet effet un substrat est disposé dans une chambre fermée et en équilibre sur des picots. Il est en outre couvert d'une monture en forme d'entonnoir à fond plat et à large ouverture renversée. Un flux de gaz est introduit par le tuyau de l'entonnoir et est réparti obliquement sur la face du substrat en regard par un filtre muni de plusieurs ouvertures disposées en biais par rapport au plan du substrat. Par l'application de ce flux à travers ces ouvertures obliques, le substrat est mis en flottement dans la chambre de manière à permettre son chauffage par un moyen électromagnétique sans déperdition de chaleur. Les gaz nécessaires au dépôt de $SiO_2$ sont amenés en même temps que le gaz de sustentation et le dépôt se fait essentiellement sur la face du substrat qui regarde les orifices d'entrée de gaz. Le document cité apprend que dans ces conditions le substrat peut aussi tourner.

Selon le document cité, dans une autre mise en oeuvre, le dispositif connu consiste en une chambre de recuit pour réaliser l'étape de recuit d'une couche de photorésist déposée sur un substrat semiconducteur dans un processus de photolithographie lors de la réalisation d'un circuit intégré.

Dans la chambre se trouve une monture de centrage (jig) à fond interne plat pour recevoir le substrat et en outre munie de rebords. Cependant le substrat ne repose pasdirectement sur le fond plat de la monture de centrage. Il est disposé sur des cales, elles-mêmes posées sur ce fond plat.

Le dispositif comprend de plus des moyens pour soulever le substrat au-dessus des câles, de manière à ce qu'il flotte à une petite distance au-dessus de ces dernières. Ces moyens de mise en sustentation consistent en l'arrivée d'un flux gazeux par un tuyau qui traverse la paroi inférieure de la chambre. Ce tuyau amène le flux gazeux jusqu'à la face inférieure du fond plat de ladite monture de centrage (jig) et se subdivise en quatre tuyaux linéaires, de diamètre inférieur, inclinés sur la verticale, de manière à transporter le flux en s'évasant vers les bords du substrat. Ces petits tuyaux traversent la paroi du fond plat de la monture (jig) pour déboucher à sa surface supérieure exactement sous le substrat monté sur cales. Ainsi le flux peut arriver à la surface inférieure du substrat et le mettre en sustentation au-dessus des câles.

Le dispositif connu possède en outre des moyens pour mettre le substrat en rotation, après sa mise en sustentation. Les quatre petits tuyaux linéaires cités plus haut sont non seulement en position oblique par rapport à l'axe vertical concrétisé par le tuyau principal d'amenée de flux, mais sont en outre disposés tangentiellement à ce dernier. C'est cette disposition qui induit un mouvement de rotation au substrat lorsque le flux est appliqué avec un débit suffisant pour provoquer un mouvement tourbillonnaire en venant buter sur les rebords de la monture.

Le dispositif connu possède en plus des moyens de chauffage de l'échantillon sous la forme d'un générateur de micro-ondes et d'un guide d'onde.

Dans le système connu, la monture de centrage (jig) constitue donc le porte-échantillon bien qu'il n'ait de contact avec l'échantillon que par l'intermédiaire des cales.

Ce porte-échantillon, monture (jig) + cales n'est pas mobile. Il est fixe. C'est l'échantillon seul qui est mis en sustentation et en rotation. Tous les moyens de mise en sustentation et rotation sont parties intégrantes du porte-échantillon. En opération, l'échantillon n'est plus en contact avec le porte-échantillon.

Le dispositif de chauffage à micro-ondes chauffe donc la couche de photorésist de l'intérieur, mais ne chauffe ni le substrat, ni le porte-échantillon. En particulier toute la chambre reste à basse température.

D'autre part, le flux gazeux qui coopère à la sustentation et à la rotation du substrat n'a aucun rôle dans les opérations de traitement de l'échantillon.

Ainsi, aucune de ces deux mises en oeuvre citées ne montre de moyens pour un centrage précis de l'échantillon tournant. D'autre part, les moyens pour faire flotter et tourner l'échantillon, ne comprennent aucun moyen destinés spécifiquement à produire la rotation réellement uniforme de cet échantillon.

C'est pourquoi la présente invention propose un dispositif avec un disque tournant, applicable par exemple à une chambre d'épitaxie en phase vapeur comme porte-échantillon, qui permet de résoudre ces problèmes.

Selon l'invention, ces problèmes sont résolus par un dispositif tel que défini dans le préambule, caractérisé en ce que la structure de centrage inclut un premier profil convexe relatif à l'une des surfaces en regard lors de la sustentation/rotation, c'est-à-dire soit à la surface du plan de référence, soit à la surface inférieure du disque, et inclut un second profil concave complémentaire du premier, relatif à l'autre surface en regard respectivement, les deux profils étant emboîtés l'un dans l'autre de manière telle que le profil convexe peut tourner librement dans le profil concave, tout en évitant le déplacement latéral du disque, en ce que pour mettre le disque en sustentation le plan de référence comprend une première structure formée de n > 2 orifices non alignés, réalisés dans la région délimitée par la projection du bord externe du disque, orifices par lesquels est appliqué, perpendiculairement à la surface du disque en regard du plan de référence, un premier flux gazeux, en sorte qu'une fente de dimension h non nulle est obtenue entre la face arrière du disque et la plan de référence, et en ce que pour mettre le disque en rotation, le plan de référence ou la face inférieure du disque comprend une seconde structure formée d'au moins une rainure arrondie, dans laquelle circule un second flux gazeux, tournant dans le sens choisi pour la rotation.

Le dispositif selon l'invention présente alors, entre autres, les avantages suivants :

- l'absence de pièces mécaniques qui traversent la paroi de référence est d'une part favorable au travail à des températures élevées, et d'autre part favorable à l'introduction dans la chambre de gaz polluants tels que l'arsine ou la phosphine, sans crainte de fuites ;
- un bon contact thermique, par conduction dans le gaz, avec la paroi de référence. En effet, l'épaisseur de la couche de gaz entre le disque et cette paroi est généralement très faible. Ceci est également favorable à l'application de ce disque dans une chambre d'épitaxie ;
- la mise en rotation est produite par des moyens spécifiques distincts des moyens de sustentation. On peut donc mettre le porte-échantillon en sustentation sans rotation. De même on peut arrêter facilement la rotation et rester en sustentation ;
- la mise en rotation et l'arrêt du mouvement sont aisés à commander, du fait qu'ils dépendent simplement de la mise en circulation d'un flux gazeux ;
- la technique proposée est particulièrement adaptée à la mise en oeuvre de mouvements planétaires par simple superposition de plusieurs plateaux tournants sur un plus grand plateau tournant. La réalisation d'un tel mouvement par des moyens mécaniques classiques, par exemple à l'aide d'engrenages serait extrêmement compliqué, du fait que le choix des matériaux est limité par la nécessité de pureté imposée par l'application envisagée à la chambre d'un réacteur. Ainsi dans une réalisation qui inclurait l'utilisation d'engrenage, on serait amené, pour cette application qui implique en outre de hautes températures, à utiliser des matériaux réfractaires non graissés. L'ensemble présenterait alors une usure très rapide, génératrice de poussières fines particulièrement néfastes à l'application envisagée. De plus, par de tels moyens classiques une faible distance entre plateau et surface de référence est difficile à obtenir car elle amène toujours à un contact mécanique générateur de poussière. Avec de tels moyens classiques, une plus mauvaise conduction thermique serait donc obtenue.

La description sera mieux comprise à l'aide de la description suivante, illustrée par les figures annexées dont :

- la figure 1a qui représente en coupe un dispositif selon l'invention,

EP 0 242 898 B1

- la figure 1b qui représente en coupe un second exemple de réalisation d'un dispositif selon l'invention,
- la figure 1c qui représente vu du dessus le plan de référence d'un troisième exemple de réalisation d'un dispositif selon l'invention,
- la figure 1d qui représente une coupe du dispositif illustré par la figure 1c,
- la figure 2 qui représente le schéma équivalent des résistances appliquées aux flux de gaz dans les différentes parties du système formé par un de ces dispositifs,
- la figure 3 qui représente les isobares correspondant à un flux de gaz issu d'une ouverture du plan de référence,
- la figure 4a qui représente un exemple de réalisation d'un disque muni d'un axe de rotation,
- la figure 4b qui représente un second exemple de réalisation d'un disque muni d'un axe de rotation,
- la figure 5a qui représente un disque muni d'un axe de rotation de forme jugée préférable, et muni d'un système de mise en rotation selon un exemple de réalisation mettant en oeuvre une force de viscosité,
- la figure 5b qui représente un disque muni d'un axe de rotation de forme jugée préférable, et muni d'un système de mise en rotation selon un second exemple de réalisation mettant en oeuvre une force de viscosité,
- la figure 5c qui représente la surface de référence selon la figure 5b, vue du dessus,
- la figure 6a qui représente un disque muni d'un axe de rotation de forme considérée comme préférable et muni d'un système d'entraînement en rotation selon un exemple de réalisation mettant en oeuvre des forces d'inertie,
- la figure 6b qui représente un disque muni d'un axe de rotation de forme jugée préférable et muni d'un système de mise en rotation selon un autre exemple de réalisation mettant en oeuvre des forces d'inertie,
- la figure 7a qui représente une vue éclatée et en perspective d'un dispositif permettant la rotation planétaire de plusieurs disques, dans une des réalisations conforme à l'invention,
- la figure 7b qui représente la surface supérieure du disque de base dans le cas d'une rotation planétaire dans un exemple de réalisation.
- la figure 8 qui montre un dispositif permettant de faciliter l'arrêt de la rotation dans une position choisie, appliqué aux disques à rotation planétaire.

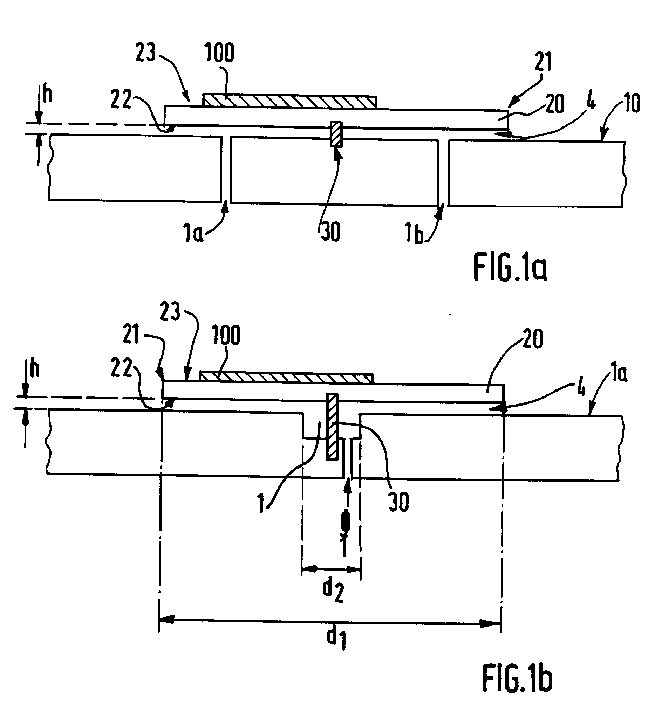

Tel que représenté sur la figure 1a, le dispositif selon l'invention est constitué d'un plateau tournant 20, autour d'un axe 30, parallèlement à un plan de référence 10, l'axe 30 étant perpendiculaire à ce plan.

Dans la description suivante, on choisira de préférence un plateau en forme de disque.

Selon l'invention, ce plateau 20 est à la fois maintenu en sustentation au-dessus de la surface 10, et mis en rotation autour de l'axe 30 par l'action d'un flux de gaz ou de plusieurs flux de gaz.

La figure 1a, montre en coupe que le plateau 20 est en sustentation à une distance $\underline{h}$ de la surface de référence 10.

La sustentation est obtenue dans l'exemple de réalisation représenté figure 1a, par des arrivées de gaz 1a, 1b, ... 1n telles que le système est en équilibre, le flux d'arrivée de gaz étant d'autre part perpendiculaire au plan du plateau 20 et du plan 10.

En situation de sustentation, le gaz injecté par les arrivées 1a, 1b, ... 1n, dans l'intervalle entre le plateau 20 et la surface de référence 10, va trouver une résistance aux flux dans la fente 4 de hauteur $\underline{h}$, provoquant une augmentation de pression sur la surface 22 du disque 20, par rapport à la pression ambiante. Le flux de gaz sera prévu suffisamment important pour que la différence entre cette pression et la pression ambiante intégrée sur la surface 22, soit au moins égale à la force de gravité sur le disque 20.

Dans un état stationnaire de sustentation, cette différence de pression est fixée par le poids du disque 20 et ne peut augmenter. En effet, pour toute augmentation lente du flux, le plateau tend à se soulever et la hauteur $\underline{h}$ tend à s'agrandir. La résistance de la fente 4 diminue alors, et l'équilibre des faces se rétablit.

Dans l'application réelle, le plateau 20 doit supporter une masse, par exemple un échantillon 100, lequel peut être décentré. Dans ce cas, le système est dissymétrique et il faut s'assurer que la hauteur $\underline{h}$ de la fente 4 reste en tout point différente de 0, c'est-à-dire que la distribution de la pression sur la surface inférieure 22 du plateau 20 prend également une allure dissymétrique correspondante, auquel cas la sustentation peut être dite stable.

Lorsque l'arrivée de gaz 1 est unique, et placée de telle sorte qu'elle coïncide avec l'axe de symétrie du plateau non chargé, étant dans le cas où le plateau est un disque, en coïncidence avec l'axe de rotation 30, alors le système est totalement symétrique et la hauteur de la fente $\underline{h}$ est donnée par la relation :

4

$$h = [(3\eta/\pi\,\rho_D\,g\,)\,(1 - d_2^2/d_1^2).\,\text{Deb}]^{1/3} \qquad 1/$$

relation dans laquelle :

$\eta$ est la viscosité du gaz

$\rho_D$ est la masse par unité de surface du disque 20

g est l'accélération de la pesanteur

$d_1$ est le diamètre du disque

$d_2$ est ici le diamètre de l'arrivée du gaz

Ce système est représenté sur la figure 1b.

Dans le cas où ce système à alimentation unique est chargé de façon dissymétrique, le domaine de stabilité dépendant du rapport des diamètres $d_1$ et $d_2$ et du débit de gaz, il apparaît que le domaine de stabilité est assez réduit, ce qui se traduit par le fait que le décentrage de la masse 100 supportée par le plateau 20 ne peut pas être grand.

Selon l'invention, une autre disposition d'arrivée du gaz est jugée préférable pour agrandir le domaine de stabilité. Cette disposition préférentielle comprend l'arrivée du gaz par $\underline{n}$ > 2 ouvertures non alignées 1a, 1b,...1n.

De préférence, ces orifices 1a...1n, se déduisent les uns des autres par une rotation de $2\pi/n$.

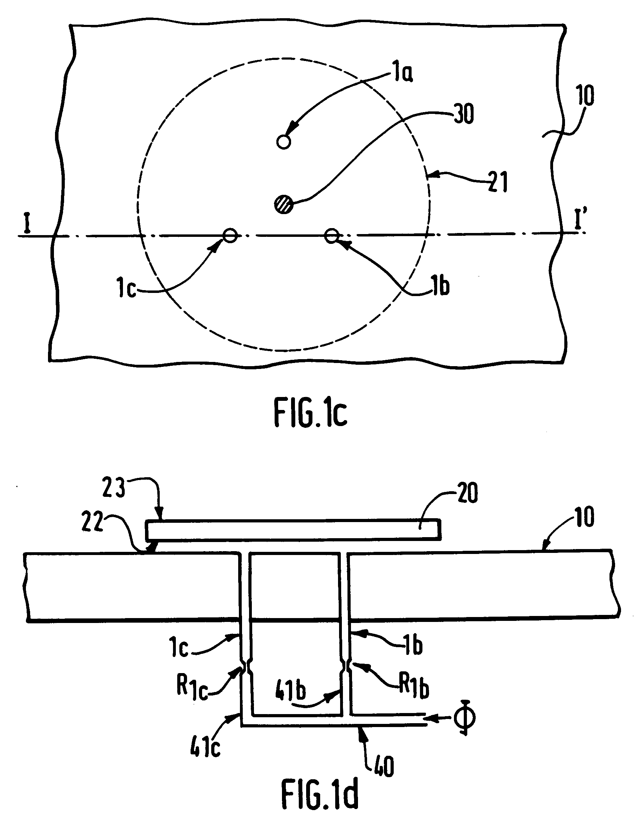

Dans les exemples de réalisation de la présente invention décrits ci-après, une disposition d'arrivée de gaz comprenant trois ouvertures 1a, 1b, 1c placées aux sommets d'un triangle équilatéral dont le centre de symétrie coïncide avec l'axe de rotation, a été choisie. Cette disposition est illustrée par la figure 1c qui représente vu du dessus la surface 10 de la paroi de référence. La trace du disque sustenté est représentée en 21 par un trait discontinu.

La figure 1d montre le même système, en coupe selon l'axe I-I' passant par le centre de deux des ouvertures 1b et 1c. Cette figure montre que ces ouvertures 1b et 1c sont raccordées à une ligne d'alimentation 40 en gaz, par l'intermédiaire des tubes 41b et 41c. L'ouverture 1a, qui ne se trouve pas dans le plan de la figure 1d, est de même raccordée à la ligne 40 par un tube. En outre les alimentations 41a, 41b, 41c sont munies de restrictions $R_{1a}$, $R_{1b}$, $R_{1c}$, constituant des résistances $R_i$. Chaque résistance $R_i$ est de valeur supérieure ou au moins équivalente à la résistance R de la fente 4 dans la partie de cette fente de hauteur h située entre l'arrivée du gaz, par exemple 1a, localisée dans le plan de référence 10, et l'ambiante située autour du système formé par le disque.

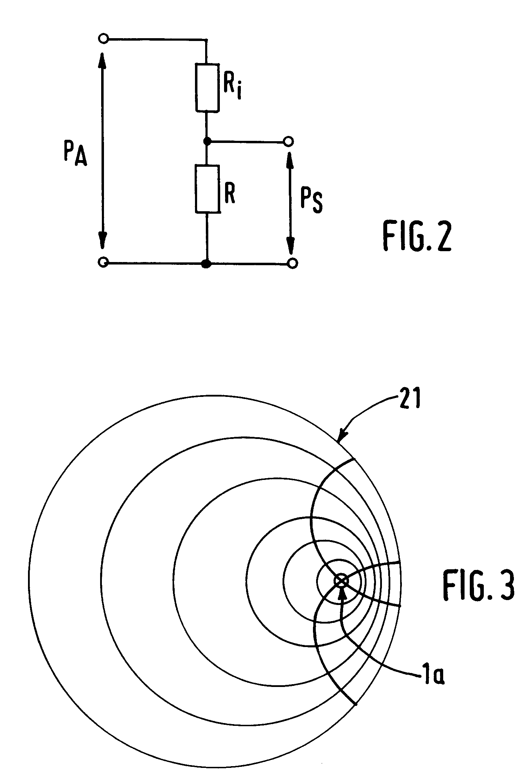

Ces résistances $R_i$ ont pour effet de stabiliser la valeur du flux $\phi_1$ au niveau du débouché des arrivées de gaz 1a, 1b, 1c. La figure 2 donne le schéma équivalent du système muni de résistances $R_{1a}$, $R_{1b}$, $R_{1c}$. Sur ce schéma $p_A$ représente la pression d'alimentation de l'un des tubes, $R_i$ la résistance placée sur ce tube, R la résistance dans la fente près de l'arrivée de gaz et $p_S$ la pression de sustentation.

Pour une arrivée de gaz, par exemple 1a fortement décentrée par rapport à l'axe de symétrie (ou de rotation 30) les isobares de pression de sustentation, représentées figure 3, montrent que, dans le cas où la hauteur h de la fente 4 est la même en tout point, la pression de sustentation s'applique de façon prépondérante près de ladite ouverture 1a. La plus grande partie du flux, dont la valeur locale est donnée par la distance entre deux isobares, passe dans la région située entre l'orifice 1a d'arrivée de gaz, et le bord 21 du disque 20.

Il est donc clair que s'il apparaît une variation de la hauteur h d'un bord à l'autre du disque 20, c'est principalement la hauteur locale près de l'orifice d'arrivée de gaz qui détermine la résistance R.

Si une masse est placée sur le plateau 20, en coïncidence avec la localisation d'un orifice d'arrivée de gaz, par exemple 1a, la valeur de h diminue à cet emplacement et la valeur de la résistance R augmente. Il s'ensuit (voir figure 2) que la pression de sustentation $p_S$ augmente également et contribue sélectivement à la sustentation au voisinage dudit orifice 1a.

Au moyen de ce mécanisme, une bonne stabilité de sustentation est obtenue à l'aide du flux gazeux.

Cependant, pour éviter le déplacement latéral du disque sustenté, il est nécessaire de le localiser, sans toutefois empêcher sa rotation autour de son axe de symétrie. A cet effet, plusieurs méthodes peuvent être utilisées.

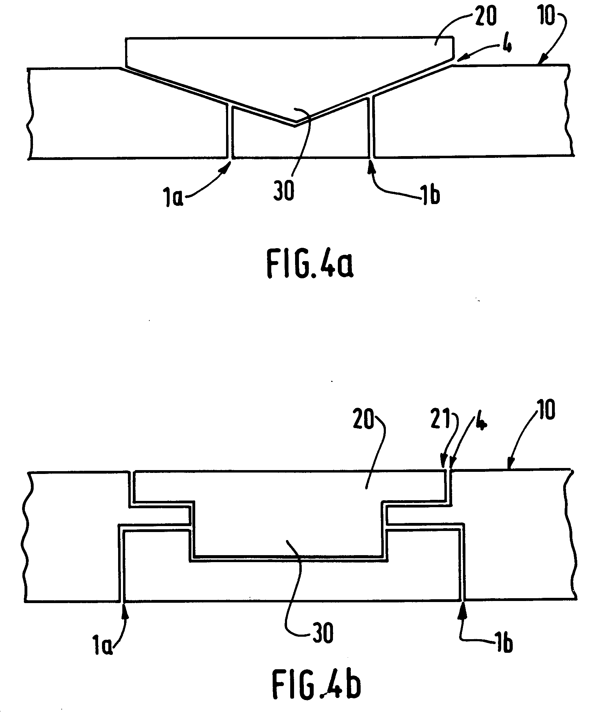

Les figures 4a et 4b montrent chacune une réalisation possible de cette localisation par un profil découpé de la surface de référence 10 et un profil complémentaire de la surface 22 du disque 20. Ce type de localisation peut être associé à plusieurs méthodes de mise en rotation du disque exposées plus loin.

Toutefois, pour obtenir un dispositif moins critique dans son élaboration, il est jugé préférable pour appliquer au mieux l'invention à une chambre d'épitaxie, de choisir une localisation du disque par un axe de rotation cylindrique 30.

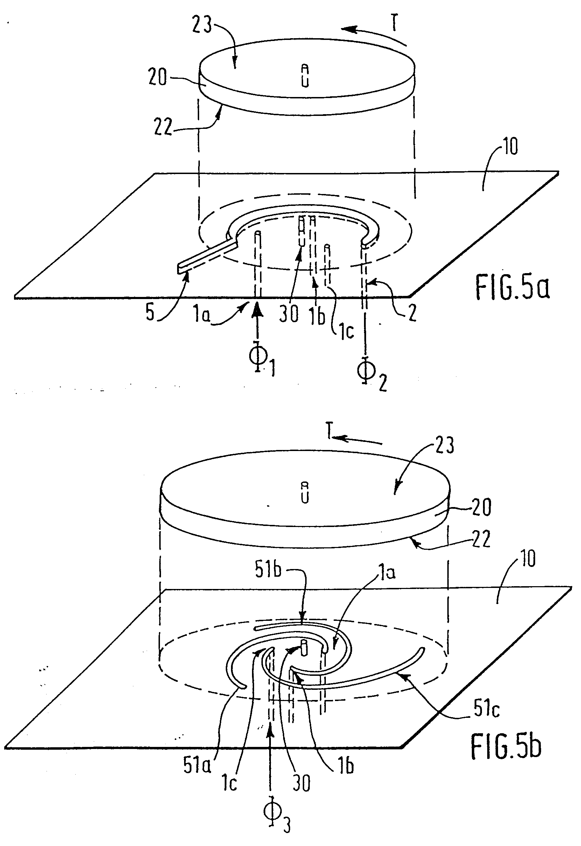

Les diverses méthodes de mise en rotation du disque-selon l'invention sont exposées dans des exemples de réalisation incluant ce dernier procédé de localisation (figures 5a et suivantes).

L'entraînement en rotation peut alors être obtenu au moyen d'une méthode choisie parmi les deux méthodes décrites ci-après ou au moyen d'une composition de ces deux méthodes.

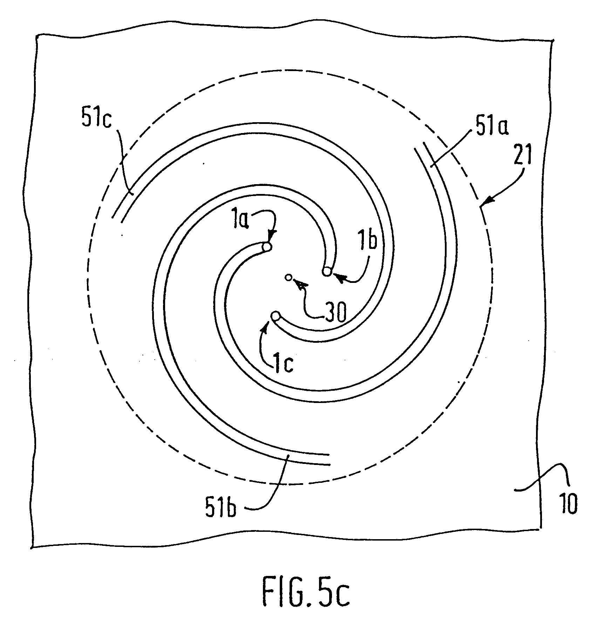

La première méthode consiste en un entraînement en rotation par une force de viscosité. Selon cette méthode, une force $F_V$ est appliquée sur une partie de la surface 22 du disque en sustentation. Cette force provoque au voisinage de cette surface 22 un courant de gaz montrant une composante de vitesse dans la direction de rotation illustrée par la flèche T, comme il est représenté sur les figures 5, qui montrent deux dispositifs conformes à cette méthode. La partie de la surface 22 du disque sur laquelle s'exerce cette force, étant essentiellement lisse, la force s'applique part un effet de viscosité du gaz. Cette force s'exprime par la relation :

$$F_V = \eta \cdot \partial V / \partial Z \qquad 2/$$

dans laquelle : $F_V$ est la force par unité de surface,

$\partial V/\partial Z$ la dérivée de sa vitesse dans la direction perpendiculaire à la surface 22.

Cette force peut encore s'exprimer par la relation de proportionnalité $= F_V \alpha \eta \cdot Deb \qquad 3/$
dans laquelle Deb est le débit.

Dans le cas où le système est utilisé à une température élevée, le volume du gaz augmente. En ce qui concerne d'autre part la viscosité $\eta$ elle-même, elle augmente pour tous les gaz lorsque la température croit. Donc pour obtenir une même force de viscosité appliquée sur le disque à une température plus élevée, il est besoin d'un débit massique moins grand. Le système est donc parfaitement adapté aux températures élevées.

Un exemple de réalisation mettant en oeuvre 1a force de viscosité d'un gaz pour obtenir la rotation du disque 20 précédemment décrit, est montré en perspective figure 5a, en vue éclatée afin de mettre en évidence les moyens de la mise en rotation.

Tel que représenté sur la figure 5a, le dispositif selon l'invention comprend donc un disque 20 muni d'un axe 30. La face 22 du disque est, comme il a été dit, essentiellement lisse. L'entraînement en rotation est obtenu dans le sens de la flèche T du fait qu'un flux de gaz $\phi_2$ est introduit dans la rainure 5 pratiquée dans la surface de référence 10 par l'arrivée 2. Cette rainure 5 est de forme arrondie et de rayon inférieur à celui du disque, afin que le flux $\phi_2$ puisse agir sur ce dernier par viscosité. La dimension transversale de la rainure peut être de 0,1 mm à plusieurs centimètres. La surface 10 comprend en outre comme il a été dit précédemment au moins 3 orifices 1a, 1b, 1c pour l'arrivée du flux de gaz $\phi_1$ servant à la sustentation.

En fonctionnement le disque 20 est placé par rapport à la surface 10, de la manière qui est montrée sur la figure 1a.

Un ou plusieurs flux de gaz peuvent être utilisés pour la mise en rotation du disque 20. L'alimentation des arrivées 1a, 1b, 1c peut être faite selon une méthode illustrée par la figure 1d. L'alimentation de l'arrivée 2 peut également être faite selon cette méthode.

Un second exemple de réalisation mettant en oeuvre la force de viscosité d'un gaz pour obtenir la rotation du disque 20 précédemment décrit, est montré en perspective figure 5b, en vue éclatée, afin de mettre en évidence les moyens de la mise en rotation.

Tel que représenté sur la figure 5b, le dispositif selon l'invention comprend donc un disque 20 muni d'un axe 30. La face 22 du disque 20 est ici encore essentiellement lisse. L'entraînement en rotation est obtenu dans le sens de la flèche T du fait qu'un flux de gaz $\phi_3$ est introduit dans les rainures 51a, 51b, 51c, pratiquées dans la surface de référence 10, par les arrivées respectivement 1a, 1b, 1c. Ces rainures 51a, 51b, 51c sont de forme arrondie et ne s'étendent pas au-delà de la trace 21 du bord du disque, afin que le flux $\phi_3$ puisse agir sur ce dernier par viscosité. La figure 5c représente un exemple de réalisation de ces rainures vu du dessus.

Le nombre des rainures 51 peut ne pas être limité à trois, tout comme le nombre des arrivées 1. La dimension transversale des rainures peut être de 0,1 mm à plusieurs centimètres et leur profondeur de 10$\mu$m à plusieurs millimètres

Dans l'exemple de réalisation illustré par la figure 5b, la fonction de mise en rotation et la fonction de sustentation stable sont combinées, puisque chaque orifice 1a, 1b, 1c d'arrivée de gaz pour la sustentation correspond à une rainure 51a, 51b, 51c pour la mise en rotation.

Il a été montré plus haut que des variations de température sur le porte-échantillon d'une chambre d'épitaxie pouvaient engendrer des variations de l'homogénéité des couches épitaxiales. L'homme du métier sait que, en outre, si des structures telles que des rainures sont pratiquées sur la face arrière du porte-échantillon, alors l'image thermique de ces structures apparait sur les couches épitaxiales terminées, sous la forme de défaut d'homogénéité. C'est pourquoi ces structures devront, autant que faire se peut, être évitées pour une telle application, ou bien leur présence devra être restreinte au bord du disque, dans une zone non destinée à recevoir un échantillon.

Dans les exemples illustrés par les figures 5a et 5b, ces rainures sont donc pratiquées de façon avantageuse dans le plan de référence 10, plutôt que dans la surface 22.

La seconde méthode d'entraînement en rotation citée précédemment, consiste en un entraînement par des forces d'inertie.

En effet, il est possible d'exercer un mouvement angulaire sur le disque sustenté, en faisant buter un flux de gaz sur une structure quelconque, solidaire du disque. Différentes structures, aptes à mettre le disque en mouvement lorsqu'elles reçoivent un flux de gaz, sont possibles. Une structure préférable pour l'application à une chambre d'épitaxie est présentée plus loin.

Au moyen d'une telle structure, le gaz transmet alors au disque une partie de sa quantité de mouvement, cette quantité de mouvement est proportionnelle à $\rho.v^2$, $\rho$ étant la masse du gaz par unité de volume, ce qui s'écrit :

$$F_i \, \alpha \, \rho \, .V^2 \qquad 4/$$

ou ce qui peut être aussi écrit :

$$F_i \, \alpha \, \rho \, . \, Deb^2 \qquad 5/$$

En comparant les relations 3 et 5, il peut être constaté que la force obtenue par inertie augmente moins en fonction de la température que la force obtenue par viscosité. Cependant, l'une et l'autre méthode sont parfaitement utilisables aux températures élevées.

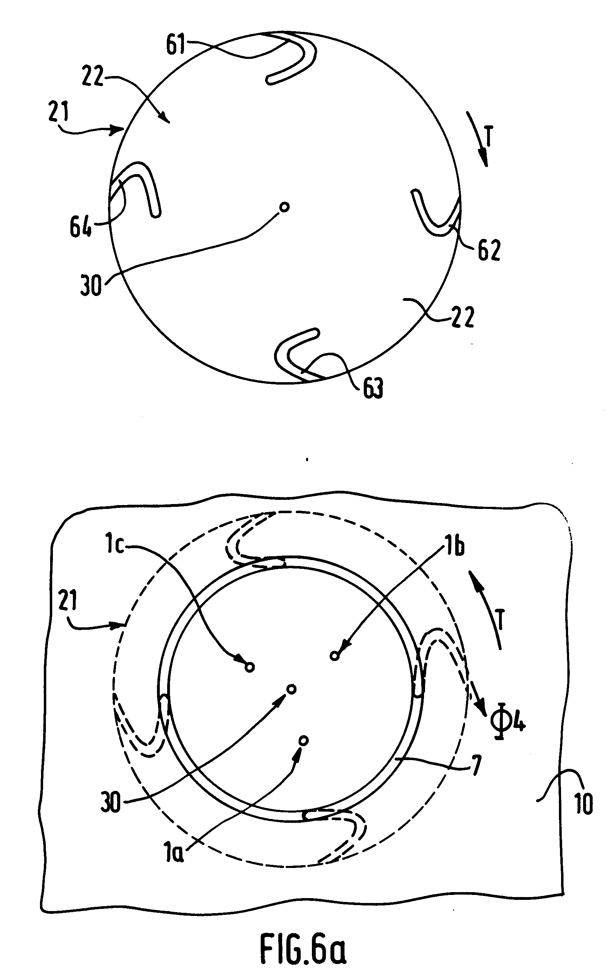

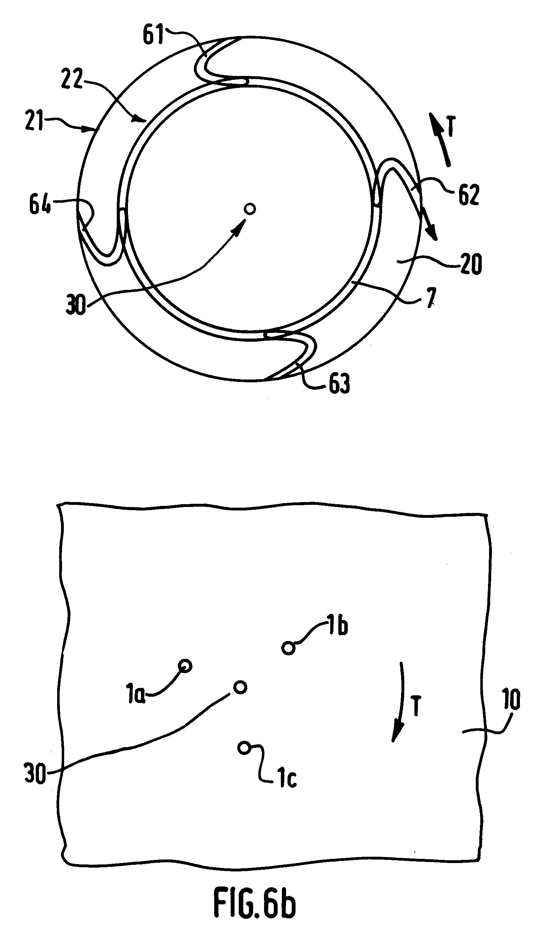

Un exemple de réalisation, mettant en oeuvre les forces d'inertie d'un gaz pour obtenir la rotation du disque 20 précédemment décrit, est montré sur les figures 6a et 6b.

La figure 6a montre la disposition de rainures 61, 62, 63, 64 pratiquées dans la surface 22 du disque 20 et qui constituent les structures contre lesquelles vient buter le flux de gaz $\phi_4$.

Pour l'application à une chambre d'épitaxie, ces structures seront réalisées de préférence à la périphérie du disque 20, comme il a été dit précédemment.

Ces rainures 61, 62, 63, 64 sont, dans cet exemple de réalisation, globalement en forme d'U et débouchent sur le bord 21 du plateau 20. Ces rainures sont ici au nombre de n' = 4 et se déduisent les unes des autres par une rotation de $2\pi/4$.

Ces rainures 61, 62, 63, 64 sont alimentées par une rainure circulaire 7, qui peut être pratiquée soit dans le plan de référence 10, comme il est montré figure 6a, soit dans la surface 22 du disque comme il est montré figure 6b, où elle débouche alors directement sur lesdites rainures 61, 62, 63, 64.

Ainsi selon l'invention un ou plusieurs flux de gaz sont suffisants pour mettre en sustentation et entraîner en rotation un disque.

En ce qui concerne le comportement à des pressions différentes de la pression ambiante pour les deux méthodes d'entraînement préconisées par l'invention, les relations données précédemment pour les forces en permettent une évaluation.

Pour l'entraînement par viscosité, en effet, on peut écrire que :

$$F_v \, \alpha \, \eta \, . \, Deb = \eta \, . \, Deb_o \, . \, p/ \, p_o \qquad 3/$$

relation dans laquelle $Deb_o$ est le débit à la pression ambiante

$P_o$ est la pression ambiante

p est la pression de travail.

La viscosité $\eta$ n'est pas, en premier ordre, fonction de la pression, et ceci pour tous les gaz, pourvu que cette pression soit suffisamment élevée pour que le libre parcours des molécules n'excède pas la dimension caractéristique de la structure parcourue, ici l'épaisseur de la fente 4 qui est h (typiquement $50\mu m$ à $100\mu m$). Cette méthode d'entraînement et de sustentation est applicable à tous gaz à toutes pressions au-delà de cette limite, c'est-à-dire en pratique au-dessus de 0,1 mbar.

7

Pour réaliser la même force d'entraînement par viscosité à une pression diminuée d'un facteur K, on peut donc diminuer le débit massique du même facteur K.

Une analyse analogue, en partant de la relation :

$$F_i \alpha \rho . Deb^2 \qquad 5/$$

pour l'entraînement par force d'inertie, montre que dans ce cas la diminution du débit massique est de $\sqrt{K}$.

Pour des pressions très basses, l'entraînement par viscosité est donc plus économe en débit de gaz.

Cette invention peut être appliquée de façon avantageuse à la réalisation de porte-échantillons pour chambre d'épitaxie en phase vapeur.

On a vu que le comportement des différents systèmes proposés, lorsque la température croît, est excellent.

On a vu aussi que la disposition des structures de sustentation ou d'entraînement en rotation est très favorable à l'obtention de couches homogènes.

Des conditions supplémentaires pour obtenir des couches homogènes sont d'une part un bon contact thermique entre le porte-échantillon et le plan de référence qui forme la source de chaleur, et d'autre part, une rotation uniforme des échantillons comme il a été enseigné par la première publication citée au titre d'état de la technique.

Dans l'application particulière à la réalisation de couches épitaxiales de matériaux du groupe III-V, le porte échantillon 20 est porté à une température de l'ordre 600°C à 850°C, par proximité du plan de référence 10 constitué par la paroi inférieure de la chambre d'épitaxie qui transmet la cha leur d'une source. Le dépôt en phase gazeuse se fait à l'aide de matériaux sous forme gazeuse mêlés par exemple à de l'hydrogène qui constitue alors un gaz vecteur.

Il est alors particulièrement avantageux d'appliquer l'invention à la réalisation du porte-échantillon de la chambre d'épitaxie en choisissant ce même gaz vecteur pour constituer le flux de gaz provoquant la sustentation et l'entraînement en rotation.

La mise en oeuvre de la sustentation et de l'entraînement en rotation est alors particulièrement simple.

Pour améliorer encore l'homogénéité des couches, il peut être prévu d'équiper la surface supérieure du disque 20 de plusieurs disques supports d'échantillons, tournant chacun par rapport au disque 20, selon une des méthodes décrites précédemment, et constituant ainsi une rotation dite "planétaire" pour les échantillons.

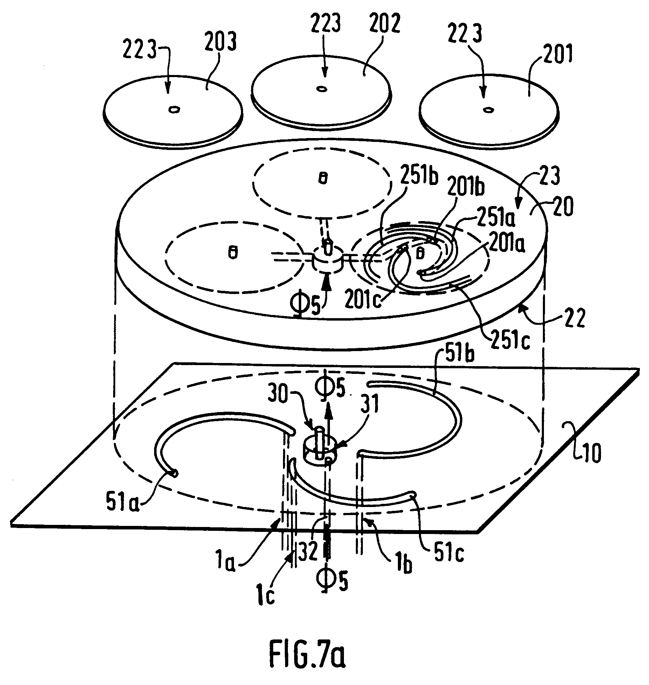

La figure 7a montre un exemple de réalisation dans lequel un nombre n" = 3 disques tournent selon un principe déjà décrit, et illustré par la figure 5b.

Dans cet exemple de réalisation le disque 20 est mis en sustentation et en rotation respectivement par un flux de gaz arrivant par les ouvertures 1a, 1b, 1c non alignées et se propageant dans les rainures arrondies 51a, 51b, 51c. Autour de l'axe 30 de rotation du plateau 20 est prévu l'arrivée d'un flux $\phi_5$ se propageant jusque dans l'épaisseur du plateau 20, épaisseur dans laquelle sont ménagées des canalisations pour amener le flux $\phi_5$ jusqu'à au moins trois orifices sous chacun des disques secondaires 201, 202, 203.

Le disque 201 est ainsi associé aux orifices 201a, 201b, 201c. Les disques 202 et 203 sont eux-mêmes associés chacun à trois orifices non représentés sur la figure 7a pour des raisons de simplicité du dessin.

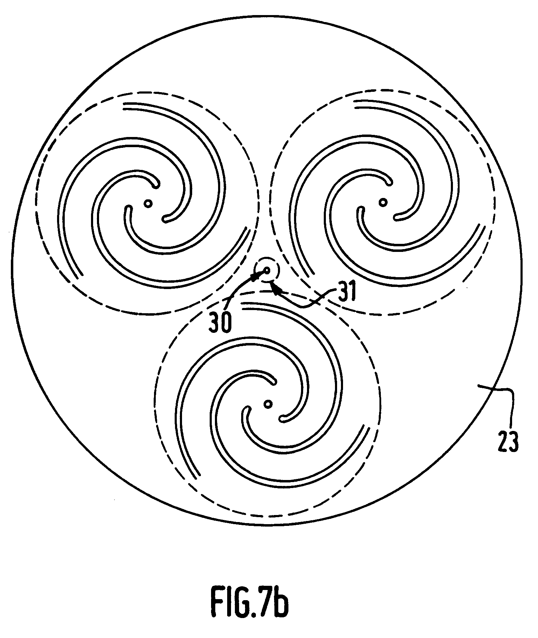

A chacun des orifices correspond une rainure courbe par exemple telle que montrée sur la figure 7b qui est une représentation de la surface 23 du disque 20. Pour les orifices 201a, 201b et 201c les rainures correspondantes sont notées 251a, 251b, et 251c.

Dans ce système, représenté figure 7a, les échantillons sont placés sur les surfaces 223 des disques 201, 202, 203. Le principe de mise en rotation est celui qui est illustré par la figure 5b, et décrit précédemment.

Il est clair que chacun des principes illustrés par les figures 5a ou 6a, 6b aurait pu être utilisé, ou même combinés.

Les différents disques conformes à l'invention peuvent être réalisés en tous matériaux durs à faible déformation, y compris des polymères.

Dans l'application à une chambre d'épitaxie, ces matériaux doivent en outre être réfractaires. Ce peut être : le graphite, des métaux, des matériaux céramiques, des matériaux cristallins tels que le silicium, l'arséniure de gallium, le saphir.

Tous ces matériaux conviennent aussi bien pour le disque, l'axe ou le support.

Les gaz appropriés peuvent être choisis parmi l'hydrogène, l'azote et tous gaz neutres. Mais d'autres gaz peuvent être choisis pour des applications particulières non citées.

EP 0 242 898 B1

Un dispositif conforme à l'invention est particulièrement avantageux pour obtenir l'arrêt de la rotation dans une position déterminée. Ceci est particulièrement utile pour le chargement et le déchargement des échantillons dans le cas de la rotation planétaire.

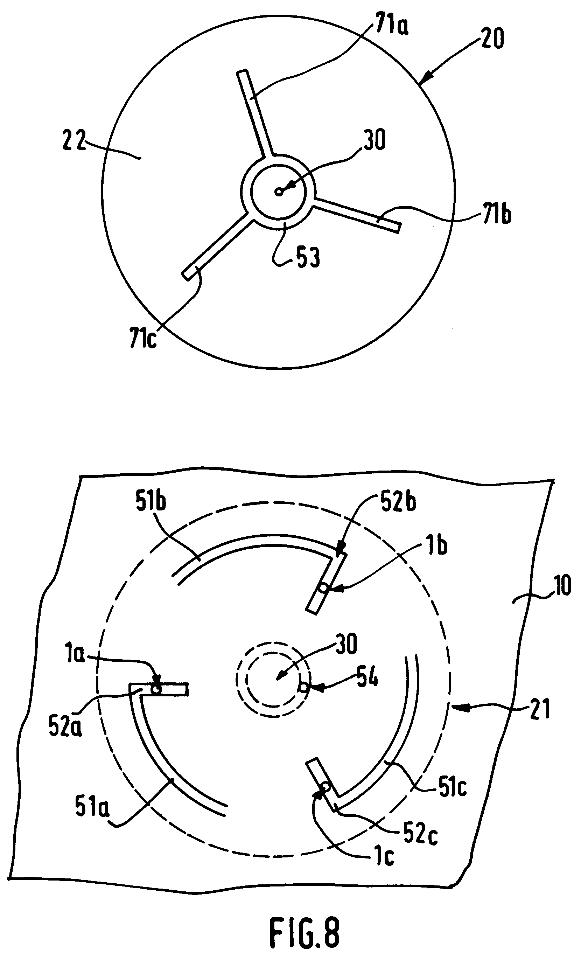

Ce dispositif est illustré par la figure 8. Cette figure représente les orifices et les rainures pratiquées dans la surface de référence 10, d'une part, et les rainures pratiquées dans la surface 22 du disque porte-échantillon d'autre part.

La surface 10 de référence comporte l'axe de rotation 30, et trois rainures 51a, 51b et 51c réalisées à proximité de la trace 21 du bord du disque. Cette surface comporte en outre, débouchant dans ces trois rainures, trois rainures radiales 52a, 52b et 52c respectivement. Les rainures 52a, 52b et 52c sont alimentées par les trois orifices 1a, 1b, 1c respectivement comme déjà décrit précédemment.

La surface 22 du disque 20 comporte une rainure circulaire 53 concentrique à l'axe de rotation et située à proximité de ce dernier, qui est dite rainure centrale. La surface 22 comporte en outre trois rainures radiales 71a, 71b, 71c. Dans une variante, la rainure centrale 53 peut être réalisée dans la surface de référence 10.

Dans la surface 10 est réalisé un orifice 54, relié à un tuyau fermé par une vanne. Cet orifice 54 dit orifice central est pratiqué vis à vis, ou débouchant dans la rainure centrale 53.

Lorsque le(s) flux de gaz arrivant par les orifices 1a, 1b, 1c est(sont) coupé(s), et lorsque la vanne fermant l'orifice central 54 est ouverte, le disque 20 s'immobilise dans la position où l'une des rainures 71a, 71b, 71c est en coïncidence avec l'une des rainures 52a, 52b, 52c. Cette structure permet donc trois positions angulaires d'arrêt du disque 20, ces positions étant espacées de 120°.

Dans le cas de la rotation planétaire, il est avantageux d'appliquer cette structure au plateau 20 et à la surface 10.

**Revendications**

1.  Dispositif comprenant un disque plan (20) tournant parallèlement à un plan de référence (10) et comprenant une structure de centrage de ce disque et des structures disposées dans le plan de référence pour mettre le disque en sustentation et en rotation par l'application d'un flux gazeux à la face arrière de ce disque, caractérisé en ce que la structure de centrage inclut un premier profil convexe (30) relatif à l'une des surfaces en regard lors de la sustentation/rotation, c'est-à-dire soit à la surface du plan de référence (10), soit à la surface inférieure du disque (22), et inclut un second profil concave complémentaire du premier, relatif à l'autre surface en regard respectivement, les deux profils étant emboités l'un dans l'autre de manière telle que le profil convexe peut tourner librement dans le profil concave, tout en évitant le déplacement latéral du disque, en ce que pour mettre le disque en sustentation le plan de référence comprend une première structure formée de n > 2 orifices (1a, 1b, 1c) non alignés, réalisés dans la région délimitée par la projection du bord externe du disque, orifices par lesquels est appliqué, perpendiculairement à la surface du disque en regard du plan de référence, un premier flux gazeux ($\phi$1), en sorte qu'une fente de dimension h non nulle est obtenue entre la face arrière du disque et le plan de référence, et en ce que pour mettre le disque en rotation, le plan de référence ou la face inférieure du disque comprend une seconde structure (5, 51a-51b-51c, 7) formée d'au moins une rainure arrondie, dans laquelle circule un second flux gazeux ($\phi$2, $\phi$3, $\phi$4), tournant dans le sens choisi pour la rotation.

2.  Dispositif selon la revendication 1, caractérisé en ce que le premier profil convexe (30) est un cylindre de petit diamètre par rapport au diamètre du disque (20), disposé à la surface du plan de référence (10), et le second profil concave est une cavité cylindrique de dimensions complémentaires disposée à la surface (22) inférieure et au centre du disque (20) et en ce que les orifices de la première structure se déduisent les uns des autres par une rotation de $2\pi/\eta$.

3.  Dispositif selon la revendication 2, caractérisé en ce que pour obtenir la mise en rotation du disque sustenté, selon une méthode dite par une force de viscosité, d'une part la seconde structure (5) est dans le plan de référence et comprend en outre un orifice (2) débouchant dans et alimentant la rainure de forme arrondie pour appliquer un second flux de gaz ($\phi$2), cette rainure étant réalisée dans la région délimitée par la projection du bord externe du disque, et suivant ce bord de disque, en tournant dans le sens choisi pour la rotation, et d'autre part cette rainure se termine hors de la région délimitée par le bord externe du disque.

9

**4.** Dispositif selon la revendication 2, caractérisé en ce que pour obtenir la mise en rotation du disque susténté selon une méthode dite par une force de viscosité, la seconde structure est dans le plan de référence et comprend n rainures arrondies (51a, 51b, 51c) dans lesquelles débouchent respectivement les n orifices (1a, 1b, 1c) par lesquels est appliqué le(s) premier(s) flux ($\phi1$, $\phi3$) servant à la sustentation, ces rainures tournant à partir des orifices dans le sens prévu pour la rotation en restant dans la région délimitée par la projection du bord externe du suscepteur.

**5.** Dispositif selon la revendication 2, caractérisé en ce que pour obtenir la mise en rotation du disque susténté selon une méthode dite par une force d'inertie, la rainure de la seconde structure (7) est dans le plan de référence et est circulaire, de diamètre inférieur au diamètre du disque, concentrique à ce dernier, et en ce que le disque comprend également une structure dite troisième structure (61, 62, 63, 64) formée de n' rainures en forme d'U, se déduisant les unes des autres par une rotation de $2\pi/n'$, et débouchant d'une part au niveau de la rainure (7) circulaire du plan de référence, et d'autre part sur le bord du disque.

**6.** Dispositif selon la revendication 2, caractérisé en ce que pour obtenir la rotation du disque susténté, selon une méthode dite par une force d'inertie, la rainure de la seconde structure (7) est dans la surface inférieure du disque et est formée d'une part d'une rainure circulaire de diamètre inférieur au diamètre du disque concentrique à ce dernier, et formée d'autre part de n' rainures (61, 62, 63, 64) en forme d'U, se déduisant les unes des autres par une rotation de $2\pi/n'$, et débouchant d'une part dans la rainure circulaire et d'autre part sur le bord du disque.

**7.** Dispositif selon l'une des revendications 5 ou 6, caractérisé en ce que n' = 4.

**8.** Dispositif selon la revendication 2, caractérisé en ce que pour obtenir la rotation du disque susténté selon une méthode dite par une force de viscosité, la seconde structure est dans le plan de référence et comprend :

a) n rainures courbes (51a, 51b, 51c) disposées parallèlement au bord du disque, et comprend en outre :

b) n rainures disposées radialement (52a, 52b, 52c) dans la région délimitée par la projection du bord du disque, de dimension inférieure au rayon du disque, rainures dans lesquelles débouchent respectivement les n orifices (1a, 1b, 1c) par lesquels est appliqué le(s) flux servant à la sustentation, et dans lesquelles débouchent les n rainures courbes,

c) une rainure concentrique à l'axe de rotation et située à proximité de ce dernier, dite rainure centrale (53),

d) un orifice dit orifice central raccordé à une sortie fermée par une vanne, débouchant dans la rainure centrale, en ce que la face inférieure du disque comprend également une structure dite troisième structure formée de n rainures (71a, 71b, 71c) radiales de dimension inférieure au rayon des n rainures (51a, 51b, 51c) du plan de référence parallèles au bord du disque, (réalisée sur la face en regard du plan de référence), cesdites n rainures radiales débouchant au niveau de la rainure centrale (53), et en ce que pour obtenir l'arrêt du disque dans les n positions possibles où les rainures radiales du disque sont en coïncidence avec les rainures radiales du plan de référence, le(s) flux appliqué(s) sur les n orifices (1a, 1b, 1c) du plan de référence est (sont) coupés, en même temps que la vanne correspondant à l'orifice central est ouverte.

**9.** Dispositif selon l'une des revendications 3 à 8, caractérisé en ce que le disque comporte, sur sa surface (23) opposée au plan de référence, n" disques dits secondaires (201, 202, 203) dont la position se déduit par une rotation de $2\pi/n''$, ce disque muni de l'un des n" disques secondaires formant lui-même un dispositif selon l'une des revendications 3 à 8.

**10.** Dispositif selon la revendication 9, caractérisé en ce que n" = 3.

**11.** Dispositif selon l'une des revendications 1 à 10, caractérisé en ce que n = 3.

**12.** Chambre de réacteur d'épitaxie en phase vapeur, caractérisée en ce qu'elle comporte au moins un dispositif selon l'une des revendications 1 à 11 pour constituer un porte-échantillon.

**13.** Procédé de réalisation d'un dispositif semiconducteur, caractérisé en ce qu'il inclut le dépôt de couches épitaxiales au moyen de la chambre selon la revendication 12.

**Claims**

1. A device comprising a flat disc (20) which rotates parallel to a reference plane (10), and comprising a centring structure for this disc and structures arranged in the reference plane for floating and rotating this disc through the application of a gas flow to the rear surface of this disc, characterized in that the centring structure comprises a first profile (30) which is convex relative to one of the opposing surfaces during floating/rotation, *i.e.* convex either in relation to the surface of the reference plane (10) or to the lower surface of the disc (22), and comprises a second, concave profile complementary to the first, as seen in relation to the respective other opposing surface, which two profiles are arranged one inside the other in such a manner that the convex profile is capable of rotating freely in the concave profile while still preventing a lateral displacement of the disc, in that, for floating the disc, the reference plane comprises a first structure formed by $n > 2$ non-aligned nozzles (1a, 1b, 1c) provided in a region bounded by the projection of the outer edge of the disc, through which nozzles a first gas flow ($\phi 1$) is provided perpendicularly to the surface of the disc facing the reference plane such that a gap with a dimension h not equal to zero is obtained between the rear surface of the disc and the reference plane, and in that, to rotate the disc, the reference plane or the lower surface of the disc comprises a second structure (5, 51a-51b-51c, 7) formed by at least one curved groove in which a second gas flow ($\phi 2$, $\phi 3$, $\phi 4$) circulates, turning in the direction chosen for the rotation.

2. A device as claimed in Claim 1, characterized in that the first, convex profile (30) is a cylinder of small diameter compared with the diameter of the disc (20), arranged at the surface corresponding to the reference plane (10), and the second, concave profile is a cylindrical cavity of complementary dimensions arranged at the lower surface (22) and at the centre of the disc (20), and in that the orifices of the first structure follow from one another by a rotation through $2\pi/\eta$ each time.

3. A device as claimed in Claim 2, characterized in that, in order to obtain the rotation of the floating disc by a method utilizing a viscosity force, on the one hand the second structure (5) is in the reference plane and comprises in addition an orifice (2) which merges into and supplies the groove of curved shape so as to provide a second gas flow ($\phi 2$), which groove is provided in the region delimited by the projection of the outer edge of the disc and follows this edge of the disc, turning in the direction chosen for the rotation, while on the other hand this groove terminates outside the region delimited by the external edge of the disc.

4. A device as claimed in Claim 2, characterized in that, so as to obtain the rotation of the floating disc by a method utilizing a viscosity force, the second structure is in the reference plane and comprises n curved grooves (51a, 51b, 51c) into which the n respective orifices (1a, 1b, 1c) merge, through which orifices the first flow(s) ($\phi 1$, $\phi 3$) is (are) applied serving to achieve flotation, these grooves turning away from the orifices in the direction envisaged for the rotation and remaining in the region delimited by the projection of the outer edge of the disc.

5. A device as claimed in Claim 2, characterized in that, in order to obtain the rotation of the floating disc by a method employing an inertia force, the groove of the second structure (7) lies in the reference plane and is circular, of a diameter smaller than the diameter of the disc and concentric with the latter, and in that the disc comprises also a structure called third structure (61, 62, 63, 64) formed by n' grooves of U-shape which follow one from the other by a rotation through $2\pi/n'$ each time, and which end on the one hand at the level of the circular groove (7) of the reference plane, and on the other hand at the edge of the disc.

6. A device as claimed in Claim 2, characterized in that, so as to obtain the rotation of the floating disc by a method utilizing an inertia force, the groove of the second structure (7) is in the lower surface of the disc and is formed on the one hand by a circular groove of a diameter smaller than the diameter of the disc and concentric with the latter, and formed on the other hand by n' grooves (61, 62, 63, 64) of U-shape which follow from one another by a rotation through $2\pi/n'$ each time, and which end on the one hand at the circular groove and on the other hand at the edge of the disc.

**7.** A device as claimed in Claim 5 or 6, characterized in that n' = 4.

**8.** A device as claimed in Claim 2, characterized in that, so as to obtain the rotation of the floating disc by a method utilizing a viscosity force, the second structure lies in the reference plane and comprises:

a) n curved grooves (51a, 51b, 51c) arranged parallel to the edge of the disc, and in addition comprises:

b) n grooves arranged radially (52a, 52b, 52c) in the region bounded by the projection of the edge of the disc, of a dimension smaller than the radius of the disc, into which grooves issue the respective n orifices (1a, 1b, 1c) through which the flow(s) serving to achieve flotation is (are) applied and into which the n curved grooves merge,

c) a groove concentric with the rotation spindle and situated close to the latter, which groove is called central groove (53),

d) a central orifice connected to an outlet closed by a valve, issuing into the central groove,

in that the lower surface of the disc also comprises a third structure formed by n radial grooves (71a, 71b, 71c) of smaller dimension than the radius of the n grooves (51a, 51b, 51c) of the reference plane parallel to the edge of the disc (realised in the surface opposite to the reference surface), the said n radial grooves issuing at the level of the central groove (53), and in that, for stopping the disc in the n possible positions in which the radial grooves of the disc coincide with the radial grooves of the reference surface, the flow(s) applied to the n orifices (1a, 1b, 1c) of the reference plane is (are) cut off while at the same time the valve corresponding to the central orifice is opened.

**9.** A device as claimed in any one of the Claims 3 to 8, characterized in that the disc comprises on its surface (23) opposite to the reference plane, n" secondary discs (201, 202, 203) whose position follows from a rotation through $2\pi/n"$ each time, which disc provided with one of the n" secondary discs itself forms a device as claimed in any one of the Claims 3 to 8.

**10.** A device as claimed in Claim 9, characterized in that n" = 3.

**11.** A device as claimed in any one of the Claims 1 to 10, characterized in that n = 3.

**12.** A reactor chamber for vapour phase epitaxy, characterized in that it comprises at least one device as claimed in any one of the Claims 1 to 11 for forming a wafer support.

**13.** A method of manufacturing a semiconductor device, characterized in that it comprises the deposition of epitaxial layers by means of the chamber as claimed in Claim 12.

**Patentansprüche**

**1.** Vorrichtung mit einer flachen Platte (20), die parallel zu einer Bezugsebene (10) drehbar ist und eine Struktur zum Zentrieren dieser Platte und Strukturen in der Bezugsebene enthält, um durch Zufuhr einer Gasströmung an der Rückseite der Platte diese Platte in den Schwebezustand und in den Rotationszustand zu bringen, dadurch gekennzeichnet, daß die Zentrierstruktur ein erstes, in bezug auf eine der einander gegenüberliegenden Flächen beim Schweben/Rotieren konvexes Profil (30), d.h. in bezug auf die Fläche der Bezugsebene (10) oder auf die untere Fläche der Platte (22), und ein zweites konkaves, dem ersten Profil komplementäres Profil in bezug auf die andere jeweils gegenüberliegende Fläche enthält, wobei die zwei Profile derart ineinander verschachtelt sind, daß das konvexe Profil sich im konkaven Profil ohne seitliche Verlagerung der Platte frei drehen kann, daß zum Erhalten des Schwebezustands der Platte die Bezugsebene eine erste, aus n) 2 nicht ausgerichteten Öffnungen (1a, 1b, 1c) gebildete Struktur in einem von der Projektion des Außenrandes der Platte begrenzten Bereichs enthält, wobei durch die Öffnungen senkrecht zur Plattenoberfläche in bezug auf die Bezugsebene ein erster gasförmiger Fluß ($\phi$1) zugeführt wird, so daß zwischen der Rückfläche der Platte und der Bezugsebene ein Spalt mit der Nicht-Null-Abmessung h entsteht, und daß zum Erhalten der Rotation der Platte die Bezugsebene oder die untere Fläche der Platte eine zweite Struktur (5, 51a-51b-51c, 7) enthält, die durch wenigstens eine gerundete Rille gebildet wird, in der ein zweiter gasförmiger Fluß ($\phi$2, $\phi$3, $\phi$4) umläuft und die sich in dem für die Rotation gewählten Sinn dreht.

**2.** Vorrichtung nach Anspruch 1, dadurch gekennzeichnet, daß das erste konvexe Profil (30) ein Zylinder mit geringem Durchmesser gegenüber dem Durchmesser der Platte (20) ist, der auf der Fläche der Bezugsebene (10) angeordnet ist, und das zweite konkave Profil ein zylindrischer Hohlraum mit komplementären Abmessungen an der unteren Fläche (22) und in der Mitte der Platte (20) ist, und daß die Öffnungen der ersten Struktur sich durch eine Rotation von $2\pi/\eta$ ableitbar sind.

3. Vorrichtung nach Anspruch 2, dadurch gekennzeichnet, daß zum Erhalten des Rotationszustands der schwebenden Platte nach einem genannten Verfahren durch eine Viskositätskraft einerseits die zweite Struktur (5) sich in der Bezugsebene befindet und außerdem eine Öffnung (2) enthält, die zum Zuführen eines zweiten Gasflusses ($\phi 2$) in die gerundete Rille mündet und sie speist, wobei diese Rille in dem von der Projektion des Außenrandes der Platte begrenzten Bereich verwirklicht wird, diesem Plattenrand folgt und sich in der für die Rotation gewählten Richtung dreht, und andererseits diese Rille außerhalb des vom Außenrand der Platte begrenzten Bereichs endet.

4. Vorrichtung nach Anspruch 2, dadurch gekennzeichnet, daß zum Erhalten des Rotationszustands der schwebenden Platte nach einem genannten Verfahren durch eine Viskositätskraft die zweite Struktur sich in der Bezugsebene befindet und n gerundete Rillen (51a, 51b, 51c) enthält, in die jeweils die n Öffnungen (1a, 1b, 1c) münden, durch die der bzw. die erste(n) Fluß bzw. Flüsse ($\phi 1$, $\phi 3$) zum Erhalten des Schwebezustands zugeführt wird bzw. werden, wobei diese Rillen von den Öffnungen in einer für die Rotation vorgesehenen Richtung drehen und dabei in dem durch die Projektion des Außenrandes des Auflagers begrenzten Bereich bleiben.

5. Vorrichtung nach Anspruch 2, dadurch gekennzeichnet, daß zum Erhalten des Rotationszustands der schwebenden Platte nach einem genannten Verfahren durch eine Trägheitskraft die Rille der zweiten Struktur (7) sich in der Bezugsebene befindet und kreisförmig ist, ihr Durchmesser kleiner als der Durchmesser der Platte ist, und daß die Platte weiter eine sog. dritte Struktur (61, 62, 63, 64) enthält, die durch n' U-förmige Rillen gebildet wird, die durch eine Rotation von $2\pi/\eta$ abgeleitbar sind, einerseits auf den Pegel der kreisförmigen Rille (7) der Bezugsebene und zum anderen an den Rand der Platte münden.

6. Vorrichtung nach Anspruch 2, dadurch gekennzeichnet, daß zum Erhalten des Rotationszustands der schwebenden Platte nach einem genannten Verfahren durch eine Trägheitskraft die Rille der zweiten Struktur (7) sich in der unteren Fläche der Platte befindet und einerseits durch eine kreisförmige Rille mit einem Durchmesser Kleiner als der Durchmesser der dazu konzentrischen Platte und zum anderen durch n' U-förmige Rillen (61, 62, 63, 64) gebildet wird, die durch eine Rotation von $2\pi/n'$ ableitbar sind, einerseits in die kreisförmige Rille und andererseits an den Rand der Platte münden.

7. Vorrichtung nach einem der Ansprüche 5 oder 6, dadurch gekennzeichnet, daß n' = 4 ist.

8. Vorrichtung nach Anspruch 2, dadurch gekennzeichnet, daß zum Erhalten des Rotationszustands der schwebenden Platte nach einem genannten Verfahren durch eine Viskositätskraft die zweite Struktur sich in der Bezugsebene befindet und folgende Elemente umfaßt:
   a) n gekrümmte Rillen (51a, 51b, 51c) parallel zum Plattenrand.
   b) n radial angeordnete Rillen (52a, 52b, 52c) in dem durch die Projektion des Randes der Platte begrenzten Bereich mit einer Abmessung kleiner als die des Plattenstrahls, wobei in diese Rillen jeweils die n Öffnungen (1a, 1b, 1c) münden, durch die der Fluß (die Flüsse) zum Erhalten des Schwebezustands zugeführt wird und in die die n gekrümmten Rillen münden,
   c) eine zur Rotationsachse konzentrische und in der Nähe dieser Achse liegende sog. zentrale Rille (53),
   d) eine sog. zentrale Öffnung in Verbindung mit einem durch einen Schieber abgeschlossenen Ausgang, der in die zentrale Rille mündet, daß die untere Fläche der Platte weiter eine sog. dritte Struktur enthält, die durch n radiale Rillen (71a, 71b, 71c) mit einer Abmessung Kleiner als die des Strahls der n parallel zur Plattenrand verlaufenden Rillen (51a, 51b, 51c) der Bezugsebene gebildet wird (auf der Fläche gegenüber der Bezugsebene verwirklicht), wobei diese n radialen Rillen auf den Pegel der zentralen Rille (53) münden, und daß zum Stoppen der Platte in den n möglichen Positionen, in denen die radialen Rillen der Platte mit den radialen Rillen der Bezugsebene zusammenfallen, der (die) nach den n Öffnungen (1a, 1b, 1c) der Bezugsebene zugeführte(n) Fluß (Flüsse) gleichzeitig mit dem Öffnen des Schiebers für die zentrale Öffnung abgeschlossen wird (werden).

13

9. Vorrichtung nach einem der Ansprüche 3 bis 8, dadurch gekennzeichnet, daß die Platte auf ihrer Fläche (23) gegenüber der Bezugsebene n" sog. sekundäre Platten (201, 202, 203) enthält, deren Position durch eine Rotation von $2\pi/n''$ ableitbar ist, wobei die Platte mit einer der n" sekundären Platten selbst eine Vorrichtung nach einem der Ansprüche 3 bis 8 bildet.

10. Vorrichtung nach Anspruch 9, dadurch gekennzeichnet, daß n" = 3 ist.

11. Vorrichtung nach einem der Ansprüche 1 bis 10, dadurch gekennzeichnet, daß n = 3 ist.

12. Reaktionskammer für Epitaxie in der Dampfphase, dadurch gekennzeichnet, daß sie zur Bildung eines Probenträgers wenigstens eine Vorrichtung nach einem oder mehreren der Ansprüche 1 bis 11 enthält.

13. Verfahren zur Verwirklichung einer Halbleitervorrichtung, dadurch gekennzeichnet, daß es die Ablagerung von Epitaxialschichten mittels der Kammer nach Anspruch 12 umfaßt.

FIG.1a

FIG.1b

FIG.1c

FIG.1d

FIG.2

FIG.3

EP 0 242 898 B1

FIG.4a

FIG.4b

FIG.5a

FIG.5b

EP 0 242 898 B1

FIG.5c

FIG.6a

FIG.6b

FIG.7a

FIG.7b

FIG.8